# EUROPEAN PATENT APPLICATION

(11) **EP 3 624 289 A1**
(43) Date of publication of application: **18.03.2020**
(21) Application number: 19193208.6
(22) Date of filing: 22.08.2019
(51) Int. Cl.: H02H 3/00

(54) **MULTI-DIMENSIONAL TRIGGERS FOR POWER CONTROL**

(30) Priority: 23.08.2018 US 201816109988
(71) Applicant: AMETEK Electronic Systems Protection, Knightdale NC 27545 (US)
(72) Inventor: PHILIP, Dean, Raleigh, North Carolina 27603 (US)
(74) Representative: Verscht, Thomas Kurt Albert

(57) **Abstract**

A power monitor establishes a three-dimensional (3D) trigger to trigger an action related to control of electrical power responsive to a reference variable indicative of a signal. The 3D trigger includes trigger conditions directed to a reference threshold, a trigger period, and a trigger number. The power monitor periodically measures the signal to produce signal values, and produces reference values for the reference variable based on the signal values. The power monitor tests whether the reference values meet the trigger conditions. The power monitor triggers or does not trigger the action when the test operation indicates or does not indicate that the reference values meet the conditions, respectively.

## Description

### BACKGROUND

Surge protection devices (SPDs) and similar power protection devices typically include an automatic switch circuit that disconnects alternating current (AC) power to the device output in response to overvoltage and/or undervoltage conditions, wiring faults, and the like. SPDs are typically designed to monitor input electrical power and to rapidly remove such power from internal and externally connected load circuits when certain threshold conditions are met. Conventional SPDs provide user mechanisms to define triggers to cause removal of power from the load circuits under only limited conditions, for example, trigger thresholds may be fixed or limited in number. The lack of flexibility results in limited protection of the circuit loads.

### SUMMARY

A power monitor performs a method that includes establishing a three-dimensional (3D) trigger to trigger an action related to control of electrical power responsive to a reference variable indicative of a signal. The 3D trigger includes trigger conditions directed to a reference threshold, a trigger period, and a trigger number. The method includes periodically measuring the signal to produce signal values, and producing reference values for the reference variable based on the signal values. The method further includes testing whether the reference values meet the trigger conditions. The method also includes triggering or not triggering the action if the testing indicates or does not indicate that the signal values meet the conditions, respectively.

### BRIEF DESCRIPTION OF THE DRAWINGS

FIG. 1 is a schematic block diagram of an example power conditioning and control apparatus (PCCA) in which embodiments presented herein may be implemented.
FIG. 2 is a diagram of an example state machine implemented in the PCCA.
FIG. 3 is a diagram of an example reference variable/state space for purposes of describing state transitions in the state machine.
FIG. 4 is a flowchart of an example method of employing a three-dimensional (3D) trigger in the PCCA to control electrical power.
FIG. 5 is a flowchart of an example method of employing multiple concurrent 3D triggers in the PCCA 10.
FIG. 6A is an illustration of an example user interface (UI) with which a user may interact to define a 3D trigger in the PCCA.
FIG. 6B is an illustration of a user definable sphere for a UI that represents a 3D trigger, visually.

### DETAILED DESCRIPTION

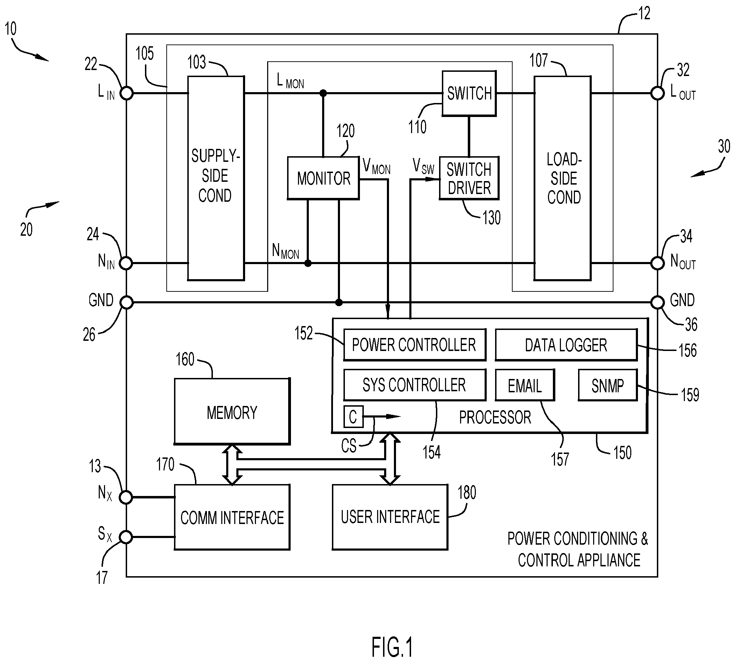

FIG. 1 is a schematic block diagram of an example power conditioning and control appliance (PCCA) 10 in which embodiments presented herein may be implemented. Exemplary PCCA 10 is an electrical circuit intended to be electrically interposed between an electrical source (not illustrated) and an electrical load (not illustrated) to improve power quality at the load and to protect both the load and internal PCCA components against various conditions where input electricity exceeds tolerances. Components other than and/or in addition to those illustrated in and described herein may be incorporated into PCCA 10. In the example of FIG. 1, a single-phase configuration with Line, Neutral, and Ground conductors is used for the purpose of explanation; it is understood that the embodiments presented herein may be applied to all alternating current (AC) and direct current (DC) electrical configuration types.

PCCA 10 accepts AC input electricity through an input port 20, and may provide conditioned AC output electricity through an output port 30. AC power conditioning may be achieved by a suitable power conditioning circuit 105 constructed or otherwise configured to filter out noise, e.g., electromagnetic interference (EMI) noise and radio-frequency interference noise (RFI), and to limit, divert and/or dissipate high energy transients and surges. Conditioning circuit 105 may include a source-side conditioner 103 and a load-side conditioner 107 comprising suitable filtering, clamping and diverter circuits and components including inductors, capacitors, varistors, silicon avalanche diodes and semiconductor switching components (SCRs, triacs, MOSFETs, etc.) suitably distributed to provide input and output electrical filtering and suppression of normal and common mode transients. One or both of source-side conditioner 103 and load-side power conditioner 107 may comprise shunt energy suppressor components to divert the energy of normal and common mode transients to the ground or neutral conductor. Additionally or alternatively, one or both of source-side power conditioner 103 and load-side power conditioner 107 may comprise series energy suppressor components to dissipate (as opposed to diverting) or limit the transient energy.

Conditioned AC power may be selectively provided to load equipment connected at output port 30 through one or more switch circuits 110, which may be compelled into respective conducting and non-conducting states in accordance with a state of a switch signal V_{SW}. In certain embodiments, output port 30 may comprise separate connectors (not illustrated), each comprising corresponding terminals 32, 34 and 36, at which respective electrical loads may be connected. When so embodied, electricity to each such connector may be independently controlled by its own switch circuit 110.

Switch circuit 110 may be compelled into its conducting state when switch signal Vsw is in a "powered" state and may be compelled into its non-conducting state when switch signal V_{SW} is in a "shutdown" state. Switch signal V_{SW} may be provided to a suitable switch driver circuit 130, in response to which switch driver circuit 130 produces sufficient voltage and current to operate switch circuit 110. Switch circuit 110 may be implemented by a hybrid switch that ameliorates power switching artifacts and/or undergoes state transitions at AC zero crossings.

PCCA 10 may include a processor 150 to implement, among other things, system coordination and control, signal and data processing, numeric computation operations, and other functions by which the circuits and subsystems of PCCA 10 operate and interoperate. For purposes of description, exemplary processor 150 realizes a power controller 152 to, among other things, control the provision of output electricity to electrical loads connected to output port 30, and a system controller 154 to, among other things, coordinate and control interoperating functional components of PCCA 10, and to interact with external agents, e.g., human users and terminal equipment. In certain embodiments, processor 150 may also implement a data logger process 156 by which system- and user-defined events are logged, an email service 157 and/or a Short Message Service (SMS) to format and transmit event and status email messages, and a simple network management protocol (SNMP) service 159 to, among other things, realize event driven and/or event related SNMP traps. Processor 150 may include a clock C to generate a clock signal CS used by processor 150 to implement programmable timers for use in operations described below. In further examples, PCCA 10 may use the Simple Network Time Protocol (SNTP) to keep track of when events occur, a Hypertext Transfer Protocol (HTTP) or HTTP Secure (HTTPS)-based web server for user interaction/control, and a command line interface for configuration and monitoring.

Processor 150 may be realized through a wide variety of processing and interface circuitry including, but not limited to analog-to-digital converter circuits, digital-to-analog converter circuits, fixed digital logic circuits, programmable digital logic circuits, application specific circuits, etc., to implement, among other components, general data processors, data-specific processors, signal converters and conditioners, analog and digital signal processors, and so on.

As used herein, one or more "reference variables" establish the system state of PCCA 10 and are assigned reference values over time from/based on signal values resulting from measurements of signals associated with electrical power, e.g., input voltage level values, input current level values, output voltage level values, output current level values, apparent power level values, active power level values, reactive power level values, power factor values, crest factor values, frequency values, energy usage, input connection polarity, temperature, humidity, external signal level values, and the like. In some embodiments, the assigned reference values may be derived from the signal values, in which case the assigned values indirectly represent the signal values. In other embodiments, the assigned values may be the signal values, in which case the assigned values directly represent the signal values. PCCA 10 transitions between various system states and performs specific actions in accordance with criteria established on the reference variables. For example, numerical bounds may be established on the reference variables, either by hard-coded mechanisms in PCCA 10 and/or by user interaction through user interface 180, to protect sensitive system functions and/or connected equipment that would be impaired if such reference variable bounds were to be exceeded.

Power controller 152 may receive one or more signals from monitor 120, each signal indicating a potentially time-varying quantity assigned to a reference variable. Monitor 120 may, for example, obtain sequential voltage measurements between AC line and neutral voltages L_{MON} and N_{MON}, respectively, and may provide the resulting voltage measurements V_{MON} to power controller 152. Power controller 152 may evaluate the voltage measurements against criteria established on the associated input voltage reference variable to determine whether a power event has occurred. As used herein, a "power event" occurs when values assigned to a reference variable meet event conditions established therefor. In response to a power event, power controller 152 may generate a corresponding power control signal V_{SW} by which switch 110 is controlled into a corresponding conducting or non-conducting state. In certain embodiments, the manner in which power controller 152 asserts the occurrence of a power event for a set event condition is user-selectable. That is, power controller 152 may assess a reference variable against a power event condition in accordance with one of different, user-selected triggers that define responsiveness in state transitions to power events, such as multi-dimensional triggers described in further detail below.

It is to be understood that while monitor 120 is illustrated in FIG. 1 as monitoring only input voltage V_{MON}, other reference variables of PCCA 10 may be monitored by monitor 120 from which occurrences of power events can be ascertained. That is, certain embodiments provide for occurrences of power events to be conditioned on reference variables other than input voltage, e.g., current, power consumption, temperature, DC input voltage (in DC power systems), non-sinusoidal signals provided from external equipment, and the like.

Exemplary user interface 180 is constructed or otherwise configured to implement various user controls by which an operator of PCCA 10 can, among other things, set various power quality and control parameters, and triggers as described below. User interface 180 may include a local interface, such as a control panel, through which PCCA operations can be monitored and certain functionality controlled. Additionally or alternatively, user interface 180 may be implemented as a remotely-accessible graphical user interface (GUI), such as through a web server (not illustrated) or cloud service (not illustrated) operating in conjunction with communication interface 170.

Memory 160 provides general and specific-purpose storage for PCCA 10, such as to store GUI components, e.g., image files and Hypertext Markup Language (HTML) encoded Web pages, as well as various system settings and data. Memory 160 may also store incident/event logs and/or diagnostic data that can be recovered or otherwise accessed through communication interface 170. Additionally, memory 160 may store processor instructions that, when executed by processor 150, causes processor 150 to perform its various functions. Memory 160 may include electrical, magnetic and/or optical storage media and associated access mechanisms including, but not limited to electronic random access and/or read-only memory, flash memory, hard disk drive memory, compact disk memory and digital versatile disk memory to implement, among other things, executable code storage, application data storage, instruction and data registers, and instruction and data caches.

Communication operations implemented by PCCA 10 may be performed by communication interface 170, which may be constructed or otherwise configured for network communications Nx, e.g., Ethernet, Wi-Fi, cellular, etc., and for serial communications Sx, e.g., Universal Serial Bus (USB), RS-232, etc. Communication interface 170 may be realized through suitable circuitry, including fixed analog and digital circuits, programmable logic and combinations thereof, that implement any and all signaling interfaces, signal processing, data conversion and data processing necessary to carry out communications on a communications network in accordance with one or more communication network protocols. Embodiments presented herein are not limited to any particular communication media, signal type or protocol; those having skill in the art will recognize numerous communication techniques that can be used.

Processor 150, memory 160, communication interface 170, and user interface 180 may be provided operating power by a suitable power supply (not illustrated), such as a linear- or switched-mode power supply, which receive conditioned AC power from power conditioning circuit 105.

The circuitry of PCCA 10 may be assembled on a common chassis or housed in a common housing generally illustrated at boundary 12, which will be referred to herein as housing 12. Input electrical terminals for line conductor L_{IN}, illustrated at terminal 22, neutral conductor N_{IN}, illustrated at terminal 24 and ground conductor GND, illustrated at terminal 26, may be disposed on the exterior of housing 12 as well as output electrical terminals for line conductor L_{OUT}, illustrated at terminal 32, neutral conductor N_{OUT}, illustrated at terminal 34 and ground conductor GND, illustrated at terminal 36. In certain embodiments, input port 20 may be assembled at the end of a power cable to include the foregoing input terminals 22, 24 and 26. Additionally, as discussed above, certain embodiments may include more than one connector at output port 30, each including corresponding output terminals 32, 34, 36. Communication port connectors may also be disposed on housing 12, such as by one or more suitable network connectors 13. Other components may be accessible from outside housing 12 as well, such as control and display panel components of a local user interface (not illustrated), visual and/or audio alarm annunciators, etc.

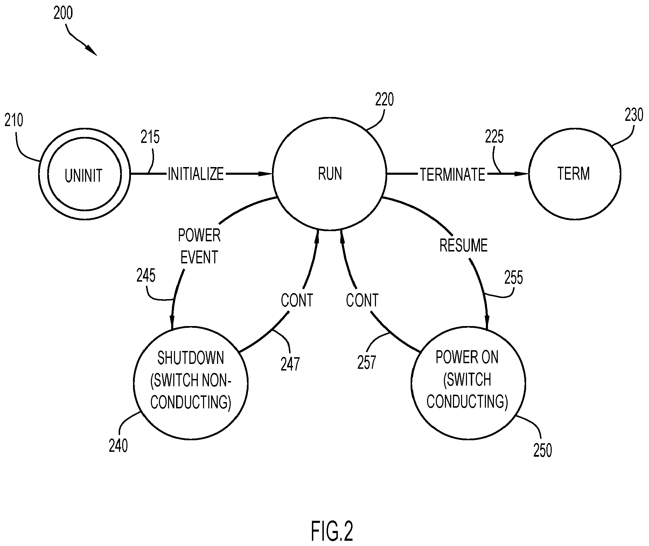

FIG. 2 is a graphical representation of an exemplary state machine 200 by which operation of power controller 152 can be demonstrated. In the diagram of FIG. 2, operational states of power controller 152 are represented by the circular nodes and events compelling transitions between states are represented by the directed line segments. Exemplary state machine 200 is instantiated in an uninitialized state 210 and transitions into run state 220 upon the occurrence of an initialize event 215, such as when all system variables and functions have been suitably initialized. While in run state 220, power controller 152 assesses monitored reference variables against power event conditions established therefor. Upon the occurrence of a power event 245 in response to, for example, an overvoltage, undervoltage, over-temperature, or other potentially damaging or unsafe condition, state machine 200 may transition into a shutdown state 240. In shutdown state 240, power controller 152 may generate switch control signal V_{SW} in a shutdown state, in response to which switch 110 is compelled into a non-conducting, or "open" state by which electrical power is removed from any load equipment connected to output port 30. A continue event 247 may occur in response to completion of the removal of power, which may compel state machine 200 to transition back into run state 220. Once power controller 152 has returned to its run state 220, reference variables are once again monitored and assessed to determine the occurrence of another power event. Upon the occurrence of a resume power event 255, which occurs when, for example, the condition under which the original power event occurred is no longer in effect or has otherwise been cleared, state machine 200 may transition into power on state 250. In power on state 250, power controller 152 may provide switch signal V_{SW} to switch 110 (through switch driver 130) in a powered state, in response to which switch 110 is compelled into a conducting, or "closed" state by which electrical power is provided to the load equipment connected to output port 30. Continue event 257 may occur upon completion of the provision of power, in response to which state machine 200 may transition back to run state 220, in which power controller 152 continues reference variable assessment operations. In response to a terminate event 225, which may occur when the user issues a "power off command or when PCCA 10 is disconnected from the AC power source, state machine 200 may transition into a terminal state 230.

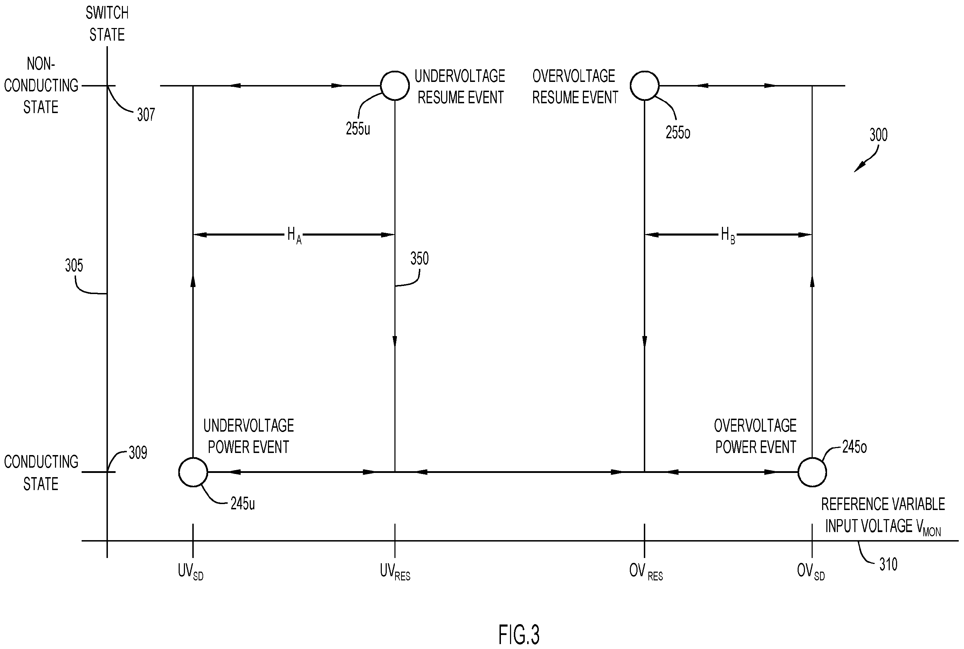

FIG. 3 is a conceptual diagram illustrating an exemplary reference variable/state (PV/State) space 300 in which changes in state 305 of switch circuit 110 occur at selected boundaries on a reference variable 310. While power controller 152 may be configured to process and operate on any number of reference variables, the reference variable of PV/State space 300 is, for purposes of description and not limitation, the monitored input voltage V_{MON}.

As illustrated in FIG. 3, changes in switch state 305 occur in PV/State space 300 where a reference variable 310, i.e., V_{MON} attains specified values referred to herein as "power event boundaries," or simply event boundaries. Event boundaries may be defined through, for example, reference boundary conditions on V_{MON}. For example, undervoltage event boundary UV_{SD} may correspond to a minimum input voltage threshold below which operation of PCCA 10 or connected electrical loads is proscribed. When V_{MON} meets or falls below UV_{SD}, power controller 152 may assert a power event 245u, in response to which switch circuit 110 is compelled into a non-conducting state 307. Similarly, overvoltage event boundary OV_{SD} may correspond to a maximum input voltage threshold above which operation of PCCA 10 or connected electrical loads is proscribed. When V_{MON} meets or exceeds OV_{SD}, power controller 152 may assert a power event 245o, in response to which switch circuit 110 is compelled into a non-conducting state 307. When PCCA 10 is operating nominally, i.e., when the V_{MON} is between UV_{RES} and OV_{RES}, switch circuit 110 may be placed in a conducting state 309, in which the load is connected to the power source connected at input port 20.

Power controller 152 may assert a resume event 255*u* when V_{MON} meets or exceeds undervoltage threshold boundary UV_{RES}, in response to which switch circuit 110 may be compelled into conducting state 309. Similarly, resume event 255o may be asserted when V_{MON} meets or falls below threshold boundary OV_{RES}, which also may compel switch circuit 110 into conductive state 309.

As illustrated in FIG. 3, the values assigned to reference variable 310 and the state 305 of the switch circuit 110 for any value of reference variable 310 defines a path in PV/State space 300, referred to herein as a process trajectory 350. It is to be understood that power controller 152 may embody multiple PV/State spaces 300, each with a corresponding process trajectory 350. In certain embodiments, process trajectory 350 includes multiple routes between states 305 to define thereby hysteresis curves, where the process will remain in one state over a range of values taken on by the reference variable until another event boundary is encountered. Using the input voltage V_{MON} exemplified above, power controller 152 may compel switch circuit 110 to remain in non-conducting state 307, having transitioned into that state 307 upon input voltage V_{MON} reaching event boundary OV_{CRIT}, until the input voltage drops to a lower value, OV_{RES} for example. At event boundary OV_{RES}, power controller 152 may compel switch circuit 110 into conducting state 309 and remain in conducting state 309 until an event boundary is encountered. In certain embodiments, the distance between routes in process trajectory 350 owing to hysteresis, representatively illustrated as distances H_{A} and H_{B}, are user-selectable values.

Embodiments presented herein are not limited to the PV/State space illustrated in FIG. 3; reference variables other than V_{MON} and states other than switch conducting states may be also be used. For example, DC signals and non-sinusoidal, time-varying signals may serve as reference variables and event actions compelled by events defined on such signals can include recording events in a data log, such as by data logger process 156, blinking/illuminating an LED on housing 12, sounding a buzzer or other audio annunciator, sending email by email service 157 and/or SNMP traps by SNMP service 159, and so on.

Embodiments presented herein are directed to user defined/programmable multi-dimensional triggers implemented in PCCA 10. The multi-dimensional triggers are described herein with reference to three-dimensional (3D) triggers, by way of example. The multi-dimensional triggers may include more than three dimensions. Each 3D trigger is configured to be responsive to an associated reference variable (e.g., RMS voltage, average voltage, peak voltage, and the like) indicative of an underlying signal (e.g., voltage), which may be related to electrical power. When activated/triggered, the 3D trigger triggers/causes PCCA 10 to perform an action with respect to power control. The action may include invoking the power events described above. Examples of 3D triggers include, but are not limited to, an overvoltage 3D trigger, an undervoltage 3D trigger, an overcurrent 3D trigger, an over-temperature 3D trigger, and a self-test 3D failure trigger. When activated, the self-test 3D trigger indicates a failure in the internal surge protection circuitry. The 3D triggers may define power event boundaries at which power controller 152 transitions into a protective shutdown state, in which switch circuit 110 transitions to its non-conducting or open state to remove power from electrical loads connected at output port 30. Alternatively, the 3D triggers may define power event boundaries at which power controller 152 transitions from the protective shutdown state to a power-on conducting state, in which switch circuit 110 is closed to apply power to electrical loads connected at output port 30.

Each 3D trigger includes three different dimensions or conditions to be evaluated with respect to the reference variable associated with that trigger. An occurrence of all three conditions being met triggers/activates the 3D trigger, which causes PCCA 10 to perform the action. More specifically, a given 3D trigger includes/is defined by (i) a reference threshold for a reference variable associated with the 3D trigger and to which the 3D trigger is responsive, (ii) a trigger time period (referred to more simply as a "trigger period"), and (iii) a trigger number, which, may represent either an absolute number or a ratio, for example. The reference threshold is a threshold against which reference values of the reference variable are to be compared. The 3D trigger may be a rising edge trigger (e.g., an overvoltage trigger), in which case the reference threshold is met/satisfied only when a reference value exceeds the reference threshold. Alternatively, the 3D trigger may be a falling edge trigger (e.g., an undervoltage trigger), which is met/satisfied only when a reference value is below the reference threshold. More generally, for each type of trigger, the corresponding reference threshold is met/satisfied only when a reference value "surpasses" the reference threshold. In the case of the rising edge trigger, "surpasses" means "exceeds," "is greater than," and the like. In the case of a falling edge trigger, "surpasses" means "is below," "is less than," and the like.

The trigger period indicates a length of time over which the reference values are to be collected for comparison against the reference threshold. The trigger period may be expressed as a time period, directly, e.g., in second, milliseconds, and so on. Alternatively, the trigger period may be expressed as a time period, indirectly, e.g., as a number of reference values, or a number of the signal values of the signal upon which the reference variable is based.

As mentioned above, the trigger number may represent either an absolute number or a ratio. When the trigger number represents an absolute number, the trigger number is a threshold/predetermined number of reference values among a total number of reference values collected during the trigger period that surpass the reference threshold. On the other hand, when the trigger number represents a ratio, the trigger number (now referred to as a trigger ratio) is a threshold/predetermined ratio of a number of the reference values among the total number of the reference values collected during the trigger period that surpass the reference threshold to the total number of the reference values. Any given ratio may be expressed as a fraction, a percentage, a proportion, or any other expression that is mathematically equivalent to a ratio.

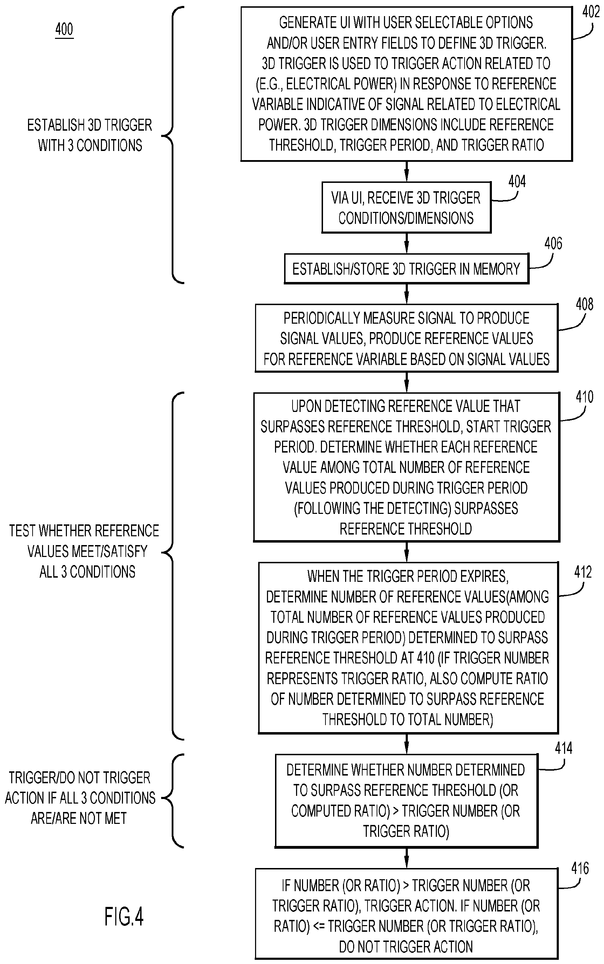

With reference to FIG. 4, there is a flowchart of an example method 400 of employing a 3D trigger in PCCA 10 to control electrical power. The operations of method 400 are performed primarily by control circuitry of PCCA 10 including monitor 120, processor 150, memory 160 coupled to the processor, user interface 180, switch driver 130, and switch 110.

In initial operations 402-406, PCCA establishes the 3D trigger to trigger an action related to control of the electrical power responsive to a reference variable indicative of a signal (e.g., voltage or current) related to/associated with electrical power. Alternatively, the signal may not be related to electrical power directly, e.g., the signal may indicate a temperature. The 3D trigger includes three trigger conditions to be tested against the reference variable to trigger firing of the 3D trigger. The three trigger conditions include/are directed to a reference threshold, a trigger period, and a trigger number, as listed above. The trigger number may represent an absolute number or a ratio (i.e., a trigger ratio). Operations 402-406 are now described in detail.

At 402, PCCA 10 generates for display a user interface including user selectable options and/or user entry fields configured to define the 3D trigger. Specifically, the user selectable options and/or user entry fields are configured to receive selections/information for the reference threshold for the reference variable associated with the signal, the trigger period, and the trigger number. The user interface may also may also include a user selectable option configured to define whether the 3D trigger is a rising edge or a falling edge trigger. The user interface may also include selectable options and/or entry fields configured to receive selections/information that defines the action to be taken when the 3D trigger is activated, i.e., the action triggered by the 3D trigger.

At 404, PCCA 10 receives via the user interface user selections and/or information entered by the user, which define the reference threshold, the trigger period, the trigger number, and optionally whether the 3D trigger is a rising edge or a falling edge trigger. PCCA 10 also receives via the user interface user selections and/or information entered by the user defining the action to be taken when the 3D trigger is activated, e.g., disconnect load or connect load.

At 406, PCCA 10 stores to memory 160 the information received at 404 as the 3D trigger.

At 408, PCCA 10 periodically measures the signal to produce signal values, and produces reference values for the reference variable based on the signal values. In an example, to produce the reference values, PCCA 10 assigns the signal values to the reference values, i.e., the reference values and the signal values are the same. In another example, PCCA 10 may derive each reference value from one or more corresponding ones of the signal values. For example, PCCA 10 may average multiple signal values to produce a given reference value. Also, PCCA 10 may derive a reference value from one or more of the signal values mathematically, using, e.g., an RMS calculation. Operation 408 represents a background operation that repeats during subsequent operations 410-416, e.g., operation 408 may be performed concurrently with the subsequent operations.

In next operations 410-414, PCCA 10 tests whether the reference values produced at 408 meet the three trigger conditions of the 3D trigger. These operations are now described in detail.

At 410, PCCA 10 compares each of the reference values to the reference threshold. Upon detecting (based on the compares) that one of the reference values surpasses the reference threshold (i.e., exceeds or is below the reference threshold when the 3D trigger is rising edge or falling edge, respectively), PCCA 10 begins a test that lasts for a length of time equal to the trigger period. PCCA 10 may use a timer programmed with the trigger period or count reference values to toll the trigger period. For the duration of test (i.e., during the trigger period), PCCA 10 determines whether each reference value among a total number of reference values produced (as a result of operation 408) surpasses the reference threshold. PCCA 10 may first record/collect the total number of reference values produced during the trigger period, and then compare each of the recorded reference values to the reference threshold after the trigger period expires. Alternatively, PCCA 10 may compare each reference value as it is produced.

At 412, when the trigger period expires, PCCA 10 determines how many (i.e., the number of) the reference values (among the total number of the reference values) that surpassed the reference threshold at 410. In a case where the trigger number represents a trigger ratio, PCCA also computes a ratio of the number of the reference values that surpassed the reference threshold to the total number of the reference values.

When the trigger number represents an absolute number, at 414, PCCA 10 determines whether the number of the reference values that surpassed the reference threshold exceeds the trigger number. Alternatively, when the trigger number represents a trigger ratio, at 414, PCCA 10 determines whether the ratio computed at 412 exceeds the trigger ratio.

When the trigger number represents the absolute number, at 416, PCCA 10 triggers the action or does not trigger the action if/when the number of the reference values that surpassed the reference threshold is determined to exceed the trigger number or not to exceed the trigger number, respectively. Alternatively, when the trigger number represents a trigger ratio, at 416, PCCA 10 triggers or does not trigger the action if/when the ratio (computed at 412) is determined to exceed or not to exceed the trigger ratio. More generally, at 416, PCA triggers or does not trigger the action if/when the testing of the three conditions performed in operations 410-414 indicates that the three conditions are met or are not met, respectively. An action may include causing or opening or closing of switch 110.

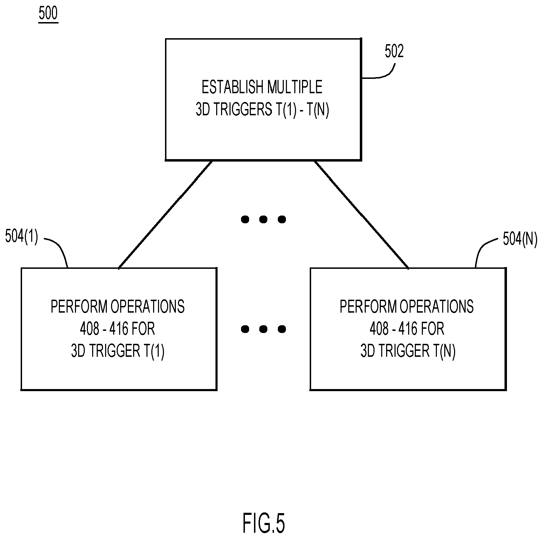

With reference to FIG. 5, there is a flowchart of an example method 500 of employing multiple concurrent 3D triggers in PCCA 10. Method 500 incorporates operations from method 400.

At 502, PCCA 10 establishes multiple distinct 3D triggers T(1)-T(N). Each 3D trigger T(i) is configured to trigger a respective action related to electrical power control responsive to a respective reference variable indicative of a respective signal related to electrical power. Each 3D trigger T(i) includes, respectively, a reference threshold, a trigger period, and a trigger number. Each 3D trigger T(i) may be established using respective sets of operations 402-406 of method 400.

At 504, PCCA 10 performs operations 504(1)-504(N), concurrently, each for a corresponding one of 3D triggers T(1)-T(N). Each method 504(i) includes operations 408-416 of method 400 performed with respect to the corresponding 3D trigger T(i). For example, operation 504(i) includes operations 408(i)-416(i) performed in connection with the reference values, signal values, reference threshold, trigger period, and trigger number corresponding to 3D trigger T(i). In an example in which all of the 3D triggers monitor a common (i.e., the same) reference variable, but have different trigger periods and different reference thresholds, all of the tests of the 3D triggers may use reference values produce by operation 408 in common.

In an example, first and second 3D triggers monitor line voltage as the reference variable. The first 3D trigger includes a reference threshold of 160 Volts for a line voltage (the reference variable), a trigger period of 200 ms, and a trigger ratio represented as an 80% hit rate. The second 3D trigger includes a reference threshold of 140 Volts for the line voltage, a trigger period of 800 ms, and a ratio represented as a 64% hit rate. The first and second 3D triggers are tested concurrently. The 3D triggers (i) cause a quick shutoff/disconnect of the line voltage due to the first 3D trigger if the line voltage experiences a large change, e.g., a jump to 200 Volts steady state, but (ii) maintain a slower shutoff time with respect to a small change that is not detected by the second 3D trigger (that has the 140 Volt threshold).

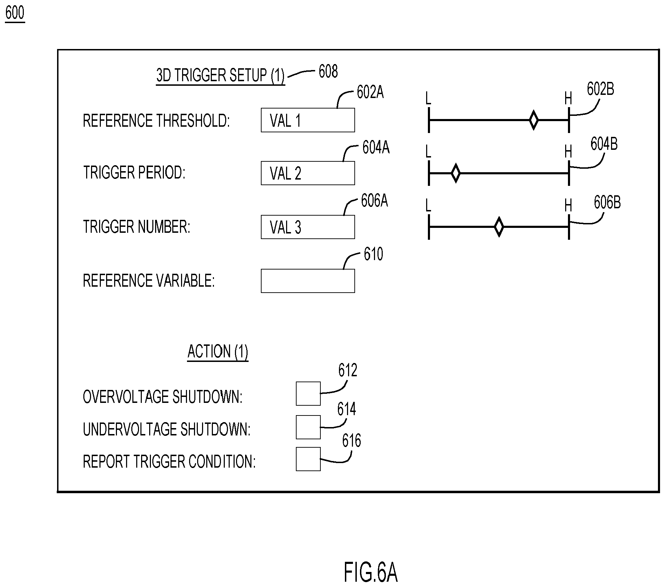

With reference to FIG. 6A, there is an illustration of an example user interface (UI) 600 with which a user may interact to define a 3D trigger, as described in connection with operations 402-406. UI 600 includes user entry fields 602A, 604A, and 606A for entry of values for a reference threshold, a trigger period, and a trigger number, respectively, associated with a 3D trigger 608. UI 600 also includes user slider selections or bars 602B, 604B, and 606B for selecting sliding values ranging from low (L) to high (H) for the reference threshold, the trigger period, and the trigger number, respectively. UI 600 includes a user entry field 610 for entry of a reference variable and/or signal associated with 3D trigger 608. UI 600 also includes user selectable options 612, 614, and 616 for actions including overvoltage shutdown, undervoltage shutdown, and report 3D trigger condition, respectively. Selection of any of options 612-616 will result in PCCA 10 performing the corresponding action when 3D trigger 608 is activated. UI 600 may automatically associate each of options 612, 614, and 616 with rising edge or falling edge triggering.

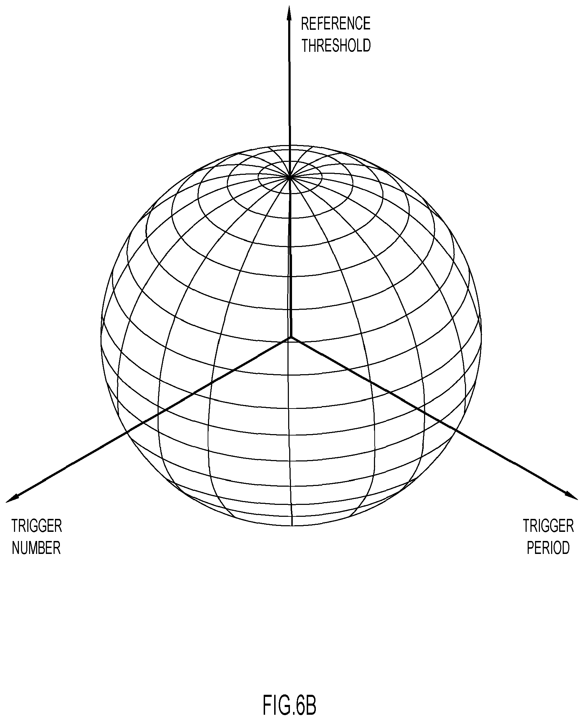

In another embodiment, each 3D trigger may be based on and visualized as a 3D function in space. In this embodiment, rather than a user having to define multiple 3D triggers as described above, the user may adjust a 3D model, mapped onto intersecting axes for reference threshold, trigger period, and trigger number, presented on a UI, as shown in FIG. 6B, described below. The 3D model defines all of the possible 3D triggers points (e.g., shutdown points) for a specific reference measurement. Once the reference measurement moves from a "safe operation volume" of the 3D function, a series of triggers may be fired. This embodiment uses repeated measurement analysis of, for example, a ring buffer for storing measurements that is the size of maximum time dimension (trigger times) for the multiple 3D triggers multiplied by the frequency of the measurements.

With reference to FIG. 6B, there is an illustration of a user definable sphere that represents a 3D trigger, according to an embodiment. The sphere is positioned with respect to axes for reference threshold, trigger number, and trigger period, and has a size and a center relative to the axes that are defined by the user. More generally, the sphere is an image of a volume that represents the 3D trigger space, visually. While the volume is represented as a sphere in the example of FIG. 6B, it is understood that the volume may be represented by other uniform shapes (e.g., a cube) and non-uniform shapes. In an embodiment, the image of the volume may be presented on a portion of UI 600 presented in FIG. 6A, for example, in a space below slider selections 602B, 604B, and 606B.

In summary, embodiments are directed to a multi-dimensional trigger that defines as trigger conditions/dimensions a reference threshold, an adjustable trigger time period, and a trigger number (i.e., either an absolute number or a ratio (e.g., percentage)). The reference dimension can be peak voltage, RMS voltage, peak current, RMS current, power, power factor, crest factor, temperature, and humidity. The time dimension is a length of time after a first occurrence of a measurement (of a reference variable) over the reference threshold. The trigger number dimension represents a number of measurements above, or below if the trigger is falling edge, the reference threshold versus the total number of measurements during a length of a test of the trigger (i.e., the trigger time period). That is, the test of the trigger lasts for the defined trigger time period, and repeatedly accumulates new measurements (of the reference variable) and compares them to the reference threshold. After the trigger time period expires, the measured number/ratio will have to be greater than the trigger number/ratio for a successful triggering/firing of the 3D trigger. That is, for the test to end in a successful trigger, the number/ratio of the measurements over the reference threshold to the total number of measurements, must be greater than the specified trigger number/ratio. Other mathematical and statistical operations may be performed besides use of absolute numbers and ratio/percentages.

A trigger, once fired, can cause several different events/actions. The events/action may include turning electrical power outlets on or off, rebooting power outlets, sending a communication to a remote server over IP, sending an SNMP trap, sending a communication to a remote client or server over IP or RS232, and the like.

In summary, in one aspect, a method is provided comprising: establishing a three-dimensional (3D) trigger to trigger an action related to control of electrical power responsive to a reference variable indicative of a signal, wherein the 3D trigger includes trigger conditions directed to a reference threshold, a trigger period, and a trigger number; periodically measuring the signal to produce signal values, and producing reference values for the reference variable based on the signal values; testing whether the reference values meet the trigger conditions; and determining whether to trigger the action in response to whether the testing indicates that the reference values meet the trigger conditions.

In another aspect, an apparatus is provided comprising: a memory; and control circuitry, including a processor, coupled to the memory, the control circuitry configured to: establish a three-dimensional (3D) trigger to trigger an action related to control of electrical power responsive to a reference variable indicative of a signal, wherein the 3D trigger includes trigger conditions directed to a reference threshold, a trigger period, and a trigger number as conditions; periodically measure the signal to produce signal values, and producing reference values for the reference variable based on the signal values; test whether the reference values meet the trigger conditions; and determine whether to trigger the action in response to whether the testing indicate that the signal values meet the conditions of the 3D trigger.

In yet another aspect, a non-transitory computer readable medium encoded with instructions is provided. The instructions, when executed by a processor, cause the processor to perform the methods presented herein.

The invention may be summarized as follows: A power monitor establishes a three-dimensional (3D) trigger to trigger an action related to control of electrical power responsive to a reference variable indicative of a signal. The 3D trigger includes trigger conditions directed to a reference threshold, a trigger period, and a trigger number. The power monitor periodically measures the signal to produce signal values, and produces reference values for the reference variable based on the signal values. The power monitor tests whether the reference values meet the trigger conditions. The power monitor triggers or does not trigger the action when the test operation indicates or does not indicate that the reference values meet the conditions, respectively.

The invention may also be summarized as follows:
1. A method performed by a power monitor comprising:
   establishing a three-dimensional (3D) trigger to trigger an action related to control of electrical power responsive to a reference variable indicative of a signal, wherein the 3D trigger includes trigger conditions directed to a reference threshold, a trigger period, and a trigger number;
   periodically measuring the signal to produce signal values, and producing reference values for the reference variable based on the signal values;
   testing whether the reference values meet the trigger conditions; and
   determining whether to trigger the action in response to whether the testing indicates that the reference values meet the trigger conditions.
2. The method of item 1, wherein:
   the testing includes, upon detecting that one of the reference values surpasses the reference threshold, determining whether each reference value among a total number of the reference values produced during the trigger period, following the detecting, surpasses the reference threshold; and
   the determining whether to trigger the action includes, when the trigger period expires, determining whether the number of the reference values determined to surpass the reference threshold exceeds the trigger number.
3. The method of item 2, wherein
   the trigger number represents a trigger ratio;
   the testing further includes computing a ratio of the number of the reference values among the total number of the reference values determined to surpass the reference threshold to the total number of the reference values; and
   the determining whether to trigger the action further includes, when the trigger period expires, determining whether the ratio exceeds the trigger ratio.
4. The method of item 2, wherein:
   the detecting that one of the reference values surpasses the reference threshold includes detecting that one of the reference values exceeds the reference threshold; and
   the determining whether each reference value surpasses the reference threshold includes determining whether each reference value exceeds the reference threshold.
5. The method of item 2, wherein:
   the detecting that one of the reference values surpasses the reference threshold includes detecting that one of the reference values is below the reference threshold; and
   the determining whether each reference value surpasses the reference threshold includes determining whether each reference value is below the reference threshold.
6. The method of any one or more of items 1 to 5, wherein the establishing includes:
   generating for display a user interface including user selectable options or entry fields configured to receive information defining the reference threshold, the trigger period, and the trigger number; and
   upon receiving the information via the user selectable options or the entry fields, storing the information in a memory.
7. The power monitor or the method of any one or more of items 1 to 6, wherein the producing includes assigning the signal values to reference values.
8. The method of any one or more of items 1 to 7, wherein the producing includes deriving each reference value based on multiple ones of the signal values.
9. The method of any one or more of items 1 to 8, wherein the periodically measuring includes periodically measuring a voltage to produce voltage values, and the producing includes producing the reference values based on the voltage values.
10. The method of any one or more of items 1 to 9, wherein the periodically measuring includes periodically measuring a current to produce current values, and the producing includes producing the reference values based on the current values.
11. The method of any one or more of items 1 to 10, wherein the trigger period is represented as a time period.
12. The method of any one or more of items 1 to 11, wherein the trigger period is represented as a number of signal measurements.
13. A power monitor comprising:
   a memory; and
   control circuitry, including a processor, coupled to the memory, the control circuitry configured to:
      establish a three-dimensional (3D) trigger to trigger an action related to control of electrical power responsive to a reference variable indicative of a signal, wherein the 3D trigger includes trigger conditions directed to a reference threshold, a trigger period, and a trigger number as conditions;
      periodically measure the signal to produce signal values, and producing reference values for the reference variable based on the signal values;
      test whether the reference values meet the trigger conditions; and
      determine whether to trigger the action in response to whether the testing indicate that the signal values meet the conditions of the 3D trigger.
14. The power monitor of item 13, wherein the control circuitry is configured to:
   test by, upon detecting that one of the reference values surpasses the reference threshold, determining whether each reference value among a total number of the reference values produced during the trigger period, following the detecting, surpasses the reference threshold; and
   determine whether to trigger the action by, when the trigger period expires, determining whether the number of the reference values determined to surpass the reference threshold exceeds the trigger number.
15. The power monitor of item 14, wherein the control circuity is configured to:
   detect that one of the reference values surpasses the reference threshold by detecting that one of the reference values exceeds the reference threshold; and
   determine whether each reference value surpasses the reference threshold by determining whether each reference value exceeds the reference threshold.
16. The power monitor of item 14, wherein the control circuity is configured to:
   detect that one of the reference values surpasses the reference threshold by detecting that one of the reference values is below the reference threshold; and
   determine whether each reference value surpasses the reference threshold by determining whether each reference value is below the reference threshold.
17. The power monitor of any one or more of items 13 to 16, wherein the control circuitry is configured to establish by:
   generating for display a user interface including user selectable options or entry fields configured to receive information defining the reference threshold, the trigger period, and the trigger number; and
   upon receiving the information via the user selectable options or the entry fields, storing the information in the memory.
18. The power monitor of any one or more of items 13 to 17, wherein the control circuitry is configured to produce by assigning the signal values to reference values.
19. The power monitor of any one or more of items 13 to 18, wherein the control circuitry is configured to produce by deriving each reference value based on multiple ones of the signal values.
20. The power monitor of any one or more of items 13 to 19, wherein the control circuitry is configured to:
   periodically measure by periodically measuring a voltage to produce voltage values, and produce by producing the reference values based on the voltage values.

The above description is intended by way of example only. The description is not intended to be exhaustive nor is the invention intended to be limited to the disclosed example embodiment(s). Many modifications and variations will be apparent to those of ordinary skill in the art without departing from the scope and spirit of the invention.

## Claims

1. A method performed by a power monitor comprising:
establishing a three-dimensional (3D) trigger to trigger an action related to control of electrical power responsive to a reference variable indicative of a signal, wherein the 3D trigger includes trigger conditions directed to a reference threshold, a trigger period, and a trigger number;
periodically measuring the signal to produce signal values, and producing reference values for the reference variable based on the signal values;
testing whether the reference values meet the trigger conditions; and
determining whether to trigger the action in response to whether the testing indicates that the reference values meet the trigger conditions.

2. The method of claim 1, wherein:
the testing includes, upon detecting that one of the reference values surpasses the reference threshold, determining whether each reference value among a total number of the reference values produced during the trigger period, following the detecting, surpasses the reference threshold; and
the determining whether to trigger the action includes, when the trigger period expires, determining whether the number of the reference values determined to surpass the reference threshold exceeds the trigger number.

3. The method of claim 2, wherein
the trigger number represents a trigger ratio;
the testing further includes computing a ratio of the number of the reference values among the total number of the reference values determined to surpass the reference threshold to the total number of the reference values; and
the determining whether to trigger the action further includes, when the trigger period expires, determining whether the ratio exceeds the trigger ratio.

4. The method of claim 2, wherein:
the detecting that one of the reference values surpasses the reference threshold includes detecting that one of the reference values exceeds the reference threshold; and
the determining whether each reference value surpasses the reference threshold includes determining whether each reference value exceeds the reference threshold.

5. The method of claim 2, wherein:
the detecting that one of the reference values surpasses the reference threshold includes detecting that one of the reference values is below the reference threshold; and
the determining whether each reference value surpasses the reference threshold includes determining whether each reference value is below the reference threshold.

6. The method of any one or more of claims 1 to 5, wherein the establishing includes:
generating for display a user interface including user selectable options or entry fields configured to receive information defining the reference threshold, the trigger period, and the trigger number; and
upon receiving the information via the user selectable options or the entry fields, storing the information in a memory.

7. The method of any one or more of claims 1 to 6, wherein the producing includes assigning the signal values to reference values.

8. The method of any one or more of claims 1 to 7, wherein the producing includes deriving each reference value based on multiple ones of the signal values.

9. The method of any one or more of claims 1 to 8, wherein the periodically measuring includes periodically measuring a voltage to produce voltage values, and the producing includes producing the reference values based on the voltage values.

10. The method of any one or more of claims 1 to 9, wherein the periodically measuring includes periodically measuring a current to produce current values, and the producing includes producing the reference values based on the current values.

11. A power monitor comprising:
a memory; and
control circuitry, including a processor, coupled to the memory, the control circuitry configured to:
establish a three-dimensional (3D) trigger to trigger an action related to control of electrical power responsive to a reference variable indicative of a signal, wherein the 3D trigger includes trigger conditions directed to a reference threshold, a trigger period, and a trigger number as conditions;
periodically measure the signal to produce signal values, and producing reference values for the reference variable based on the signal values;
test whether the reference values meet the trigger conditions; and
determine whether to trigger the action in response to whether the testing indicate that the signal values meet the conditions of the 3D trigger.

12. The power monitor of claim 11, wherein the control circuitry is configured to:
test by, upon detecting that one of the reference values surpasses the reference threshold, determining whether each reference value among a total number of the reference values produced during the trigger period, following the detecting, surpasses the reference threshold; and
determine whether to trigger the action by, when the trigger period expires, determining whether the number of the reference values determined to surpass the reference threshold exceeds the trigger number.

13. The power monitor of claim 12, wherein the control circuity is configured to:
detect that one of the reference values surpasses the reference threshold by detecting that one of the reference values exceeds the reference threshold; and
determine whether each reference value surpasses the reference threshold by determining whether each reference value exceeds the reference threshold.

14. The power monitor of claim 12, wherein the control circuity is configured to:
detect that one of the reference values surpasses the reference threshold by detecting that one of the reference values is below the reference threshold; and
determine whether each reference value surpasses the reference threshold by determining whether each reference value is below the reference threshold.

15. The power monitor of any one or more of claims 11 to 14, wherein the control circuitry is configured to establish by:
generating for display a user interface including user selectable options or entry fields configured to receive information defining the reference threshold, the trigger period, and the trigger number; and
upon receiving the information via the user selectable options or the entry fields, storing the information in the memory.
